# EUROPEAN PATENT SPECIFICATION

(11) **EP 2 494 368 B1**
(45) Date of publication and mention of the grant of the patent: **20.12.2023**
(21) Application number: 10774420.3
(22) Date of filing: 11.05.2010
(51) Int. Cl.: G01R 11/02, G01R 22/00, G08C 19/00, G01R 21/00, G08C 17/00, G08C 23/04

(54) **METER AND COMMUNICATIONS APPARATUS**
ZÄHLER UND KOMMUNIKATIONSGERÄT
APPAREIL DE COMPTAGE ET DE COMMUNICATION

(30) Priority: 11.05.2009 AU 2009902065; 19.05.2009 AU 2009100471
(43) Date of publication of application: 05.09.2012
(73) Proprietor: Landis & Gyr Pty Ltd, Alexandria, New South Wales 2015 (AU)
(72) Inventor: TORPY, Keith, Alexandria, New South Wales 2015 (AU); ROBINSON, Allan, Alexandria, New South Wales 2015 (AU); COLLINS, Paul, Alexandria, New South Wales 2015 (AU); JACOBS, Brad, Alexandria, New South Wales 2015 (AU); DEMARCO, Marcelo, Alexandria, New South Wales 2015 (AU)
(74) Representative: Marks & Clerk LLP
(86) International application number: PCT/AU2010/000545
(87) International publication number: WO 2010/129991

(56) References cited:
- EP-A1- 0 511 482
- EP-A2- 0 913 696
- EP-A2- 0 913 696
- WO-A1-99/57697
- WO-A2-2005/094371
- WO-A2-2006/024854
- CN-Y- 2 795 868
- GB-A- 2 324 610
- GB-A- 2 461 348
- JP-A- 2001 093 073
- US-A- 5 668 538
- US-A1- 2004 061 623
- US-A1- 2006 218 104
- US-A1- 2006 218 104
- US-A1- 2008 284 614
- US-B2- 7 019 666

## Description

### Field of the Invention

The present invention relates to a meter and communications apparatus and, particularly, but not exclusively, to an electricity meter and an upgradeable communications apparatus for the electricity meter.

### Background of the Invention

Meters, both domestic and industrial, for monitoring data associated with the consumption of resources such as electricity and gas, are well known. It is usually a regulatory requirement for most countries that meters be installed for monitoring resource consumption at all premises.

Advanced metering devices, for example advanced domestic and industrial electricity meters, are provided with communications apparatus to enable communication of data with a remote location. Communications functions may include reporting data to the remote location (e.g. automatic, central meter reading), providing data on resource tariff or other consumption data to a display device (for example in the home), receiving control data from a remote location for control of the meter, or any other communications requirement. The Applicant's earlier Patent Application No. 2005227360, the disclosure of which is incorporated herein by reference, discloses an electricity meter and an in-home display which receives data communicated from the electricity meter relating to aspects of consumption and cost of electricity, for display to the domestic user.

A problem with communications apparatus is that there are many different communications formats, standards and types available for use. For example, different geographical locations may have different communications types serving them. A particular brand or type of electricity meter, therefore, may have to operate in different areas which have different communications types available. Further, the same type of electricity meter may be required to provide different functionality, depending upon its application, geographical position etc. Different types of communications may therefore be required of the same type of electricity meter.

Further, communications technology is changing rapidly, as are the requirements for the amount and type of data to be communicated. There is, therefore, often a requirement for communications apparatus associated with an electricity meter to be changed or upgraded.

Electricity meters are wired into the electricity supply, so that they can monitor electricity consumption. In order to access a meter to change, upgrade or otherwise service the communications apparatus, it is usually necessary to power-down the meter and have a qualified, registered engineer carry out the access. In many jurisdictions, including Australia, meters are "*security sealed*" to guard against unauthorised access. In order to access the communications apparatus in current electricity meters, the security seal must be broken.

The documents JP 2001 093073 A and CN 2 795 868 Y disclose a meter apparatus according to the state of the art.

### Summary of the Invention

The object of the invention is solved by the features of independent claim 1. Further embodiments are the subject-matter of the dependent claims.

It is an advantage of at least an embodiment of the present invention, that the communications apparatus can be accessed for changing, upgrading or otherwise servicing, without it being necessary to affect the mains supply of electricity to the meter. In an embodiment, therefore, it is not necessary to power-down the meter, and the meter can continue functioning while the communications apparatus is being accessed. Further, in embodiments, the communications apparatus may be accessed by a person who is not a qualified and registered engineer (as is required for accessing the meter circuitry). In the embodiment where the housing comprises first and second housing portions, a person merely needs to access the second housing portion to access the communications apparatus. In an embodiment, the second housing portion may be provided with a security seal to deter unauthorised access. In an embodiment, the first housing portion may also be provided with a security seal. In an embodiment, a first access means is provided to enable access to at least the connection between the meter circuitry and the mains supply.

In an embodiment, the communications apparatus is mounted by a communications module. In an embodiment, the communications module comprises a communications module housing mounting communications circuitry. In the embodiment where the communications apparatus is mounted in a second housing portion, the second housing portion comprises a communications compartment which is arranged to receive the communications module housing. In an embodiment, the communications compartment comprises physical guides for positively locating the communications module housing. Advantageously, in an embodiment, the communications module housing is arranged to fit entirely within the footprint of the meter housing, so that it may be accessed even where there is limited mounting space for the meter apparatus.

In an embodiment, the meter circuitry comprises an electrical connector for mating with a corresponding electrical connector of the communications apparatus, whereby to provide one or both of power and data communications. In an embodiment, the electrical connector of the meter circuitry is located within the communications module compartment.

In the embodiment where the communications apparatus is mounted in a communications module housing, communication circuitry can be provided to deal with any type of communications, including RF Mesh, WiMax, and any other communications system.

In accordance with a second aspect, the present invention provides a communications apparatus arranged for connection to the meter apparatus of the first aspect of the invention, so as to be electrically isolated from the mains supply of electricity to enable access to the communications apparatus without affecting the mains supply to the meter.

In an embodiment, the communications apparatus comprises a communications module housing mounting communications circuitry, as discussed above in relation to the first aspect of the invention.

In accordance with a third aspect, the present invention provides a meter system, comprising a meter apparatus in accordance with the first aspect of the invention and a communications apparatus in accordance with the second aspect of the invention.

In accordance with a fourth aspect, the present invention provides a meter apparatus comprising a housing, the housing comprising a first housing portion mounting a meter arrangement, and a second housing portion arranged to mount a communications apparatus, the second housing portion comprising second access means, such that access can be had to the second housing portion, to access the communications apparatus, via the second access means, without requiring access to the first housing portion.

In an embodiment, the meter arrangement comprises meter circuitry arranged to be connected to a mains supply of electricity and arranged to monitor data associated with the mains supply.

In accordance with a fifth aspect, the present invention provides a method of enabling association of communications apparatus with metering apparatus in an electrical meter, the method comprising the steps of electrically isolating the communications apparatus from the meter apparatus and also physically isolating the communications apparatus by providing a separate compartment from the meter apparatus, for receiving the communications apparatus.

### Brief Description of the Drawings

Features and advantages of the present invention will become apparent from the following description of embodiments thereof, by way of example only, with reference to the accompanying drawings in which:

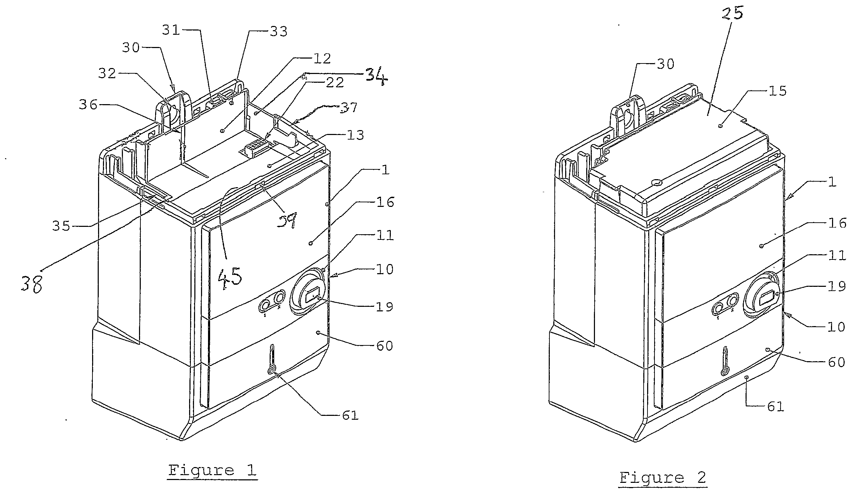

Figure 1 is a perspective view from above and one side of a meter apparatus in accordance with an embodiment of the invention, with a cover of the communications compartment removed;
Figure 2 is a perspective view from above and one side of the embodiment of Figure 1, illustrating a communications module in place;

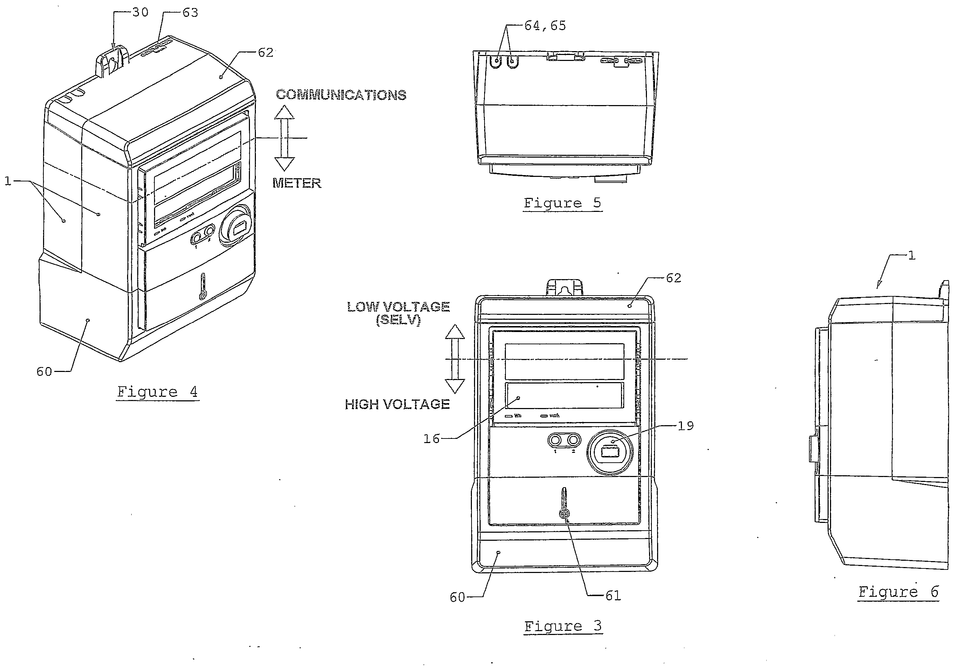

Figure 3 is a front view of the meter apparatus of Figure 1;
Figure 4 is a perspective view from above and one side of the apparatus of Figure 1, illustrating a cover of the communications compartment in place;
Figure 5 is a top view of the apparatus of Figure 4;
Figure 6 is a side view from one side of the apparatus of Figure 4;
Figure 7 is a view from above and one side of the apparatus of Figure 1 showing a communications module in place;
Figure 8 is a perspective view from above and one side of a communication module in accordance with an embodiment of the present invention;
Figure 9 is a front view of the apparatus of Figure 1, showing the cover of a meter terminal compartment removed;
Figure 10 is a view from the bottom of the apparatus of Figure 9;
Figure 11 is a top view of the apparatus of Figure 1, illustrating the communication compartment;
Figure 12 is a side view from one side of the apparatus of Figure 1, showing the communication module separate from the meter apparatus;
Figure 13 is a perspective view from above and one side of the communication module;
Figure 14 is a perspective view from above and one side of the communication module with a communication module cover removed;
Figure 15 is a front view of the communication module of Figure 13;
Figure 16 is a bottom view of the communication module of Figure 13;
Figure 17 is a top view of the communication module of Figure 13;
Figure 18 is a side view from one side of the communication module of Figure 13;
Figure 19 is a functional block diagram showing components of the meter apparatus; and
Figure 20 is a block diagram of a meter apparatus illustrating isolation circuitry between the communications and meter circuitry.

### Detailed Description of Embodiments

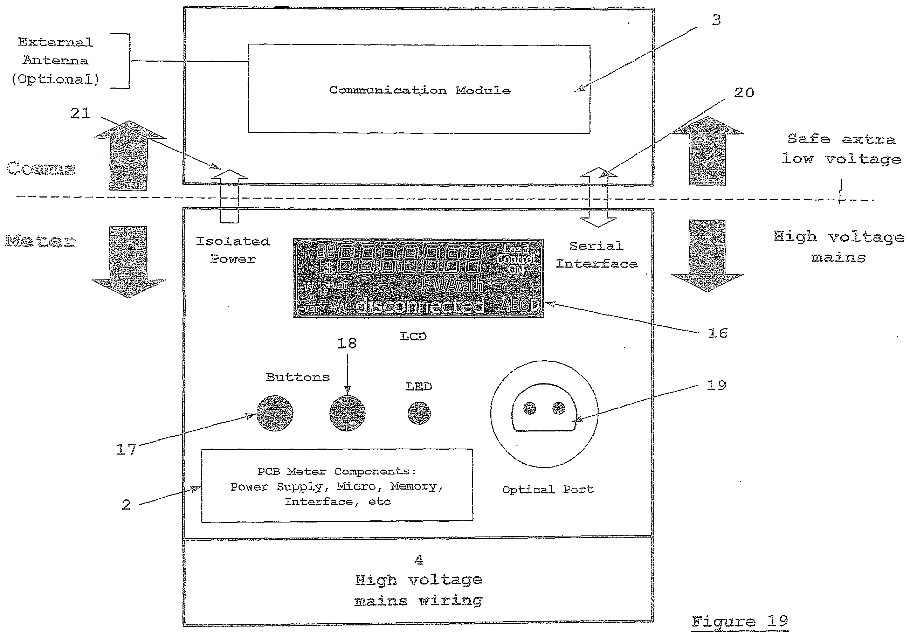

With reference to the Figures, a meter apparatus in accordance with an embodiment of the present invention is illustrated and generally designated by reference numeral 1. The meter apparatus comprises meter circuitry 2 (Figure 19) and a communications apparatus, in this embodiment comprising a communications module 3 containing communications circuitry.

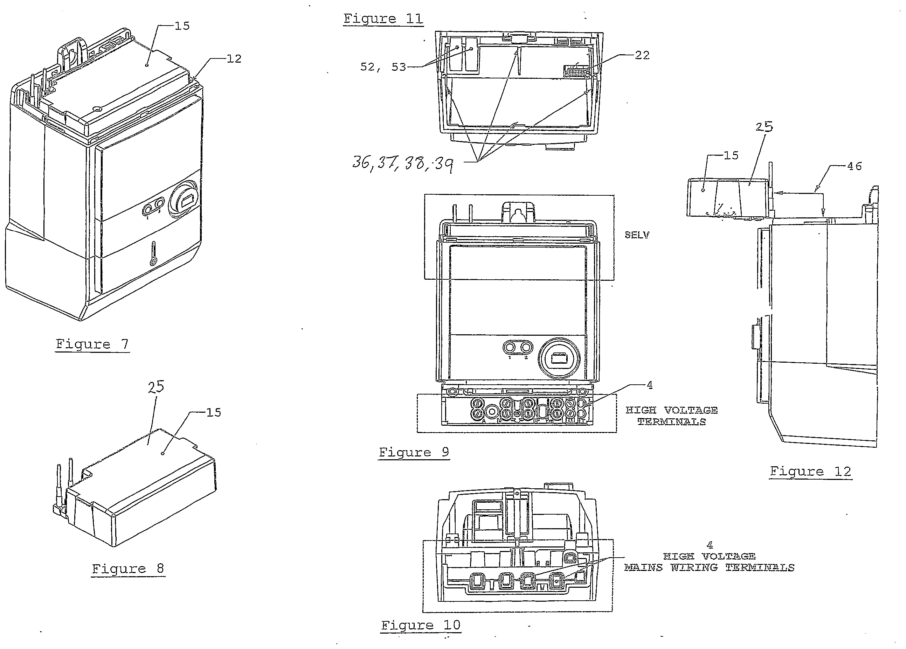

The meter circuitry is arranged to monitor data associated with the mains supply and is arranged to be connected to the mains supply. In this embodiment, high voltage terminals 4 (Figure 9 and Figure 10) are provided for connecting the mains voltage to the meter circuitry.

The meter apparatus is arranged such that the communications apparatus is electrically isolated from the mains supply of electricity to enable access to the communications apparatus without affecting the mains supply to the meter. This has the advantage that the communications circuitry may be changed, upgraded or otherwise dealt with, without it being necessary to power-down the meter and, in this embodiment, without it being necessary that a qualified engineer be required to access the meter to access the communications apparatus. This has the further advantage that, because there is no need to disconnect the power to the meter apparatus, the consumers, loads and electrical devices are unaffected.

Electrical isolation is such that the communications apparatus conforms with the requirements for Safe Extra Low Voltage (SELV).

In more detail, in this example embodiment, the meter apparatus comprises a housing 10 which has a first housing portion 11 which houses the meter circuitry and a second housing portion 12 which mounts the communications apparatus. In this embodiment, the first housing portion 11 is in the form of a first compartment 11 which houses all the meter circuitry. A dividing wall 13 divides the first compartment 11 from the second housing portion 12, in this embodiment being in the form of a communication compartment 12 for receiving a communication module 15 mounting the communications circuitry 3.

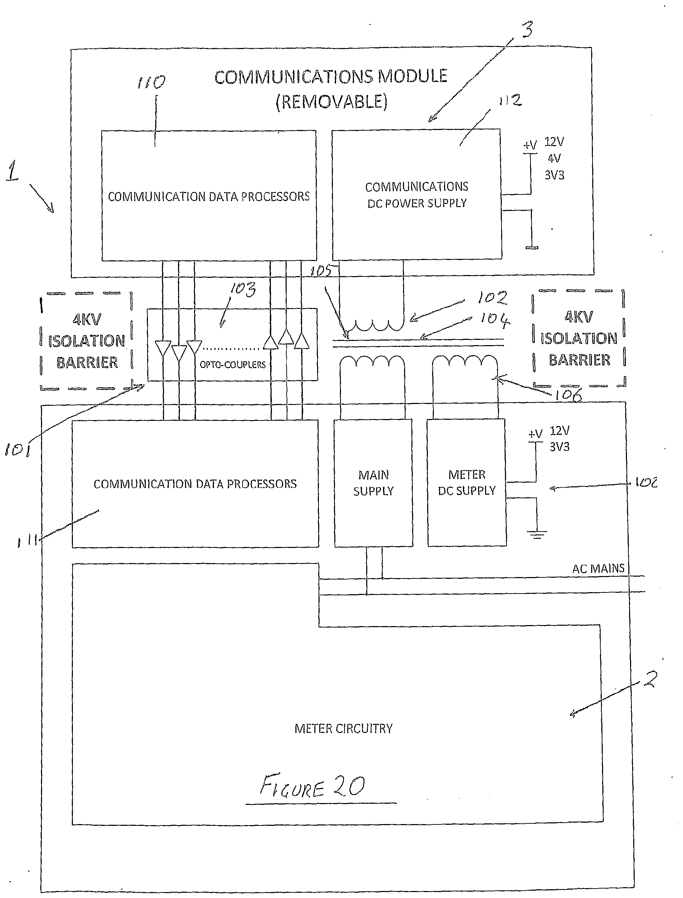

The meter circuitry may comprise any meter circuitry which is able to obtain and provide the appropriate data on the mains supply. In this embodiment, the meter circuitry is mounted on a PCB and comprises a power supply 100 (Figure 20), microprocessor for controlling the meter, memory and interface to a display 16. The meter apparatus also comprises a user interface (buttons 17, 18, and an optical port 19). A serial interface 20 is provided for communications between the communications apparatus 3 and the meter circuitry 2. Power is provided to the communications apparatus via a power supply 21. The communications apparatus 3 is isolated from the mains power supply.

A connector 22 is provided for connecting the communications apparatus 3 to the meter circuitry 2. The isolation barrier is provided for both the serial interface 20 and the supplied low voltage power 21. The connector 22 also provides connection for the low voltage power supply 21 to the communications apparatus 3.

The RS 232 serial communication link 20 between the meter circuitry 2 and the communications apparatus 3 utilises a standard ANSI C12.18 protocol. In this embodiment, the communications apparatus 3 acts as the master in this protocol and initiates all communications with the meter circuitry 2. The communications apparatus 3 can read any of the metering data - energy registers, interval data, event logs, etc from the meter circuitry 2, as well as sending commands to perform tasks such as activating relays, setting time, clearing registers etc.

Additional to the serial interface, direct signals from the meter circuitry indicating loss of power or a critical meter event are provided.

The isolated power supply to the communications apparatus 3 is 12 Volts DC, 8W.

Electricity meters, such as the meter of this embodiment, are connected directly to the mains supply (in this embodiment via terminals 4) to enable measurement of voltage and current and the calculation of energy. As a result, there is no isolation between the mains supply and the meter circuitry 2 and the meter is considered to be at mains potential.

In this embodiment, as discussed above, there are two interfaces via the single connector 22, one of the interfaces 101 (Figure 20) providing power to the communications apparatus 3 and the other of the interfaces 102 providing communications between the communications apparatus 3 and the meter circuitry 2.

In this embodiment, the communications signals are provided through opto-isolators 103 provided as the interface to the meter circuitry 2. They provide at least a 4 kV isolation barrier (in Australia this is a requirement for isolation for meter circuitry. The isolation test is 4 kV for a period of 1 minute).

The power is provided to the communications circuitry 3 via a switch mode power supply 100 that has a transformer 104 with two separate windings 105, 106 from which two separate low voltage DC supplies are derived. One 106 supplies the power to run the meter circuitry, and the other 105 is provided to the communications circuitry 3 via the connector 22. As can be seen from Figure 20, the communications apparatus comprises communications data processors 110 arranged to communicate with communications data processors 111 in the meter via the opto-couplers 103. The communications module also incorporates a DC communications power supply 112.

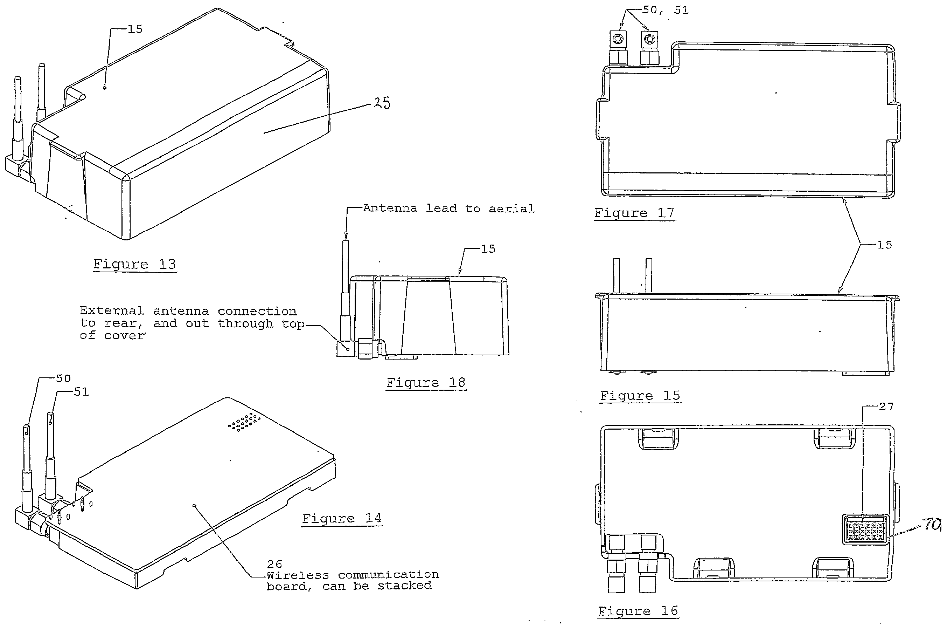

In this embodiment, the communications apparatus 3 comprises a communication module 15 (see Figures 13 to 18). This comprises a communications module housing 25 mounting within it communications circuitry. Referring to Figure 14, the circuitry is mounted on a circuit board 26. The circuitry is not shown here. It will be appreciated that any communications circuitry able to provide required communication functions can be incorporated on the circuit board 26 or otherwise mounted within the communications module housing 25. An advantage of providing the communications apparatus 3 by way of a module 15, is that a module 15 can easily be replaced to change or upgrade the communications functions. A module 15 can also be easily accessed to service or change the communications circuitry. Different modules having the same type of housing 25 may contain different communications circuitry with different capabilities, so that a particular meter apparatus may be upgraded or have its communications functions varied merely by using a module with the particular capability. A simple upgrade, for example, may be implemented by removing one module 15 and replacing it with another with changed communications functionality. The communications module housing 25 may mount any number of communications devices (e.g. for different communications types).

The communications module 15 includes a mating connector 27 for mating with the connector 22 to the meter circuitry 2 and power supply 21.

As discussed, the communications apparatus can include any communications functionality. For example, it may send or receive data and commands to/from anywhere that it is externally connected to via the technology it incorporates. In a typical advanced meter situation this may be include a connection to a central location via a LAN/WAN e.g. RF Mesh, WiMax, and also domestically or within an industrial location via a home area network (e.g. Zigbee^{™}) or other network.

Data may be communicated to a domestic display, for example, such as described in Australian Patent Application No. 2005227360, so that information on electricity consumption can be provided to a user in the home. Data may be communicated with a control location, for example to facilitate remote meter reading. Data may also be communicated from the remote location to control the meter (e.g. to automatically terminate electricity supply). Data may be communicated that is unrelated to meter operation. For example, it is envisaged that in some embodiments a broadband link for networks such as the Internet to a domestic residence could be implemented via the communications apparatus 3. The communications apparatus 3 in this instance provides an internet gateway. It is envisaged that such a communications apparatus could provide a gateway for any communications to and/or from-a dwelling or other establishment associated with the meter apparatus.

The communications module compartment 12 is provided in the upper part of the meter apparatus 1 in use. A mounting fixture 30 extends from a back wall 31 of the upper part of the meter apparatus housing 10. The fixture 30 has a hole 32 to receive a screw, bolt or the like for mounting the meter.

The communications module compartment 12 includes a back wall 33 and side walls 34 and 35 defining the communications compartment 12 together with the dividing wall 13 dividing the communications compartment 12 from the meter apparatus compartment 11. Locating guides 36, 37 38, 39 are provided in the walls for locating the communications module. The guides provide positive location guidance when connecting and disconnecting the communications module 15, to guide the connectors 22 and 27 together and maintain integrity. Further alignment is provided by a guide collar 70 (Figure 26) positioned about the mating connector 27 on the communications module 15. The collar 70 also provides protection to the mating connector 27 when the communications module 15 is uninstalled. The connector 22 protrudes from the surrounding housing so that it can be directly aligned with the mating connector 27.

A front wall 45 of the communications module compartment 12 is relatively lower than the back wall 33. The communications module housing 25 is designed so that it can be fitted solely within the meters footprint even when other equipment is in close proximity to the meter apparatus 1. Referring to Figure 12, installation of the communications module 25 is via the installation path shown by arrows 46. In operation, the communications module is slid forward and down into the communications compartment 12, being located by the guides. The communications module can be installed without it being necessary to have much or any room above the meter. It can also be removed this way. This ensures that the module can be accessed and changed in any installation, even those with limited space around the meter apparatus.

Aerial connectors 50, 51 are provided for the optional connection of external antenna (up to two) for the communications apparatus 3. Locations 52, 53 are provided to locate the external antenna connectors 50, 51 within the communications module compartment 12.

A security cover 60 is provided for the first compartment 11 enabling access to the high voltage terminals 4. The security cover 60 may be provided with a security seal 61 to deter tampering. A separate communications security cover 62 is provided for the communications compartment 12. The communication cover 62 also has a security seal 63 in this embodiment to deter tampering. The cover 62 has a pair of "*knock-out*" portions 64, 65, which are removable if antennas are required for the communications apparatus 3.

The communications compartment 12, with cover 62, is environmentally sealed to protect against water getting into the compartment.

In the above embodiment, the meter apparatus includes meter circuitry functioning as an electricity meter. In other embodiments, the two compartment approach implemented by this embodiment may be used for different types of meter apparatus. For example, a gas meter or a water meter may comprise a compartment which contains communications apparatus, separate from the water and gas meter, in a similar manner to the electricity meter embodiment described above.

The term "comprising" (and its grammatical variations) as used herein are used in the inclusive sense of "having" or "including" and not in the sense of "consisting only of".

In embodiments of this invention, any meter circuitry may be mounted within the housing 1 for providing any meter function. The invention is not limited to the meter circuitry described above.

It will be appreciated by persons skilled in the art that numerous variations and/or modifications may be made to the invention as shown in the specific embodiments without departing from the scope of the invention as defined in the claims. The present embodiments are, therefore, to be considered in all respects as illustrative and not restrictive.

## Claims

1. A meter apparatus (1), comprising a housing (10), **characterized in that** the housing (10) has first and second housing portions (11, 12), the first housing portion (11) mounting meter circuitry (2) arranged to be connected to a mains supply of electricity and arranged to monitor data associated with the mains supply, the meter apparatus (1) is configured to connect to a communications apparatus (3) mounted in the second housing portion (12) and arranged for communicating data with the meter, the communications apparatus (3) being electrically isolated from the mains supply of electricity to enable access to the communications apparatus (3) without affecting the mains supply to the meter, the first and second housing portions (11, 12) comprising first and second access means respectively, such that access can be had to the second housing portion (12), to access the communication apparatus (3) via the second access means, without requiring access to the first housing portion (11), wherein power is provided to the communications apparatus (3) via a switch mode power supply (100) that has a transformer (104) with two separate windings (105, 106) from which two separate low voltage DC supplies are derivable wherein one winding (106) supplies the power to run the meter circuitry (2) and the other winding (105) is provided to the communications apparatus (3).

2. The meter apparatus (1) in accordance with Claim 1, wherein the communications apparatus (3) is mounted by a communications module (15) comprising a communications module housing (25) mounting communications circuitry, and wherein the second housing portion (12) comprises a communications compartment which is arranged to receive the communications module housing (25), the communications compartment comprising physical guides for positively locating the communications module housing (25) within the compartment.

3. The meter apparatus (1) in accordance with Claim 2, wherein the communications module housing (25) is arranged to fit entirely within the footprint of the meter housing, whereby it may be accessed even where there is limited mounting space for the meter apparatus (1).

4. The meter apparatus (1) in accordance with Claim 2, wherein the communications module (15) incorporates a DC communications power supply (112).

5. A meter system, **characterized in that** the meter system comprises a meter apparatus according to claims 1-4 (1) and a communications apparatus (3) arranged for connection to the meter apparatus (1) according to claim 1, the communications apparatus (3) comprising a communications module housing (25) mounting communications circuitry, and being arranged to be connected to the meter apparatus (1) in a manner such that it is electrically isolated from the mains supply of electricity to enable access to the communications apparatus (1) without affecting the mains supply to the meter.

## Patentansprüche

1. Zählergerät (1) umfassend ein Gehäuse (10), **dadurch gekennzeichnet, dass** das Gehäuse (10) einen ersten und einen zweiten Gehäuseabschnitt (11, 12) aufweist, wobei der erste Gehäuseabschnitt (11) eine Zählerschaltung (2) trägt, die so angeordnet ist, dass sie mit einer Stromnetzversorgung verbunden werden kann und so angeordnet ist, dass sie der Netzversorgung zugeordnete Daten überwacht, das Zählergerät (1) so konfiguriert ist, dass es mit einem Kommunikationsgerät (3) verbunden werden kann, das in dem zweiten Gehäuseabschnitt (12) montiert und so angeordnet ist, dass es Daten mit dem Zähler kommuniziert, wobei das Kommunikationsgerät (3) von der Stromnetzversorgung elektrisch isoliert ist, um den Zugriff auf das Kommunikationsgerät (3) zu ermöglichen, ohne die Netzversorgung des Zählers zu beeinflussen, wobei der erste und der zweite Gehäuseabschnitt (11, 12) jeweils ein erstes und ein zweites Zugriffsmittel umfasst, sodass auf den zweiten Gehäuseabschnitt (12) zugegriffen werden kann, um über das zweite Zugriffsmittel auf das Kommunikationsgerät (3) zuzugreifen, ohne dass der Zugriff auf den ersten Gehäuseabschnitt (11) erforderlich ist, wobei das Kommunikationsgerät (3) über ein Schaltnetzteil (100) mit Strom versorgt wird, das einen Transformator (104) mit zwei getrennten Wicklungen (105, 106) aufweist, von denen zwei getrennte Niederspannungs-Gleichstromversorgungen abgeleitet werden können, wobei eine Wicklung (106) den Strom für den Betrieb der Zählerschaltung (2) zuführt und die andere Wicklung (105) an das Kommunikationsgerät (3) bereitgestellt ist.

2. Zählergerät (1) nach Anspruch 1, wobei das Kommunikationsgerät (3) durch ein Kommunikationsmodul (15) getragen ist, das ein Kommunikationsmodulgehäuse (25) umfasst, das eine Kommunikationsschaltung trägt, und wobei der zweite Gehäuseabschnitt (12) ein Kommunikationsabteil umfasst, das so angeordnet ist, dass es das Kommunikationsmodulgehäuse (25) aufnimmt, wobei das Kommunikationsabteil physische Führungen umfasst, um das Kommunikationsmodulgehäuse (25) in dem Abteil formschlüssig zu positionieren.

3. Zählergerät (1) nach Anspruch 2, wobei das Kommunikationsmodulgehäuse (25) so angeordnet ist, dass es vollständig innerhalb die Grundfläche des Zählergehäuses passt, wodurch es auch dann zugänglich ist, wenn der Montageraum für das Zählergerät (1) begrenzt ist.

4. Zählergerät (1) nach Anspruch 2, wobei das Kommunikationsmodul (15) eine Gleichstrom-Kommunikationsstromversorgung (112) enthält.

5. Zählersystem, **dadurch gekennzeichnet, dass** das Zählersystem ein Zählergerät (1) nach den Ansprüchen 1 bis 4 und ein Kommunikationsgerät (3) umfasst, das für den Anschluss an das Zählergerät (1) nach Anspruch 1 angeordnet ist, wobei das Kommunikationsgerät (3) ein Kommunikationsmodulgehäuse (25) umfasst, das eine Kommunikationsschaltung trägt, und so angeordnet ist, dass es mit dem Zählergerät (1) so verbunden werden kann, dass es von der Stromnetzversorgung elektrisch isoliert ist, um den Zugriff auf das Kommunikationsgerät (1) zu ermöglichen, ohne die Netzversorgung des Zählers zu beeinflussen.

## Revendications

1. Appareil compteur (1), comprenant un logement (10), **caractérisé en ce que** le logement (10) comporte une première et une seconde partie de logement (11, 12), la première partie de logement (11) portant un circuit de compteur (2) agencé pour être raccordé à une alimentation électrique par le réseau et agencé pour surveiller des données associées à l'alimentation par le réseau, l'appareil compteur (1) est configuré pour se connecter à un appareil de communication (3) monté dans la seconde partie de logement (12) et agencé pour communiquer des données avec le compteur, l'appareil de communication (3) étant électriquement isolé de l'alimentation électrique par le réseau pour permettre l'accès à l'appareil de communication (3) sans affecter l'alimentation par le réseau du compteur, la première et la seconde partie de logement (11, 12) comprenant un premier et un second moyen d'accès respectivement, de sorte que la seconde partie de logement (12) est accessible pour accéder à l'appareil de communication (3) par le biais du second moyen d'accès, sans que l'accès à la première partie de logement (11) soit nécessaire, dans lequel l'alimentation est fournie à l'appareil de communication (3) par le biais d'une alimentation à découpage (100) qui présente un transformateur (104) avec deux enroulements séparés (105, 106) à partir desquels deux alimentations CC à basse tension séparées peuvent être dérivées, dans lequel un enroulement (106) fournit l'alimentation pour faire fonctionner le circuit de compteur (2) et l'autre enroulement (105) est fourni à l'appareil de communication (3).

2. Appareil compteur (1) selon la revendication 1, dans lequel l'appareil de communication (3) est porté par un module de communication (15) comprenant un logement de module de communication (25) portant un circuit de communication, et dans lequel la seconde partie de logement (12) comprend un compartiment de communication qui est agencé pour recevoir le logement de module de communication (25), le compartiment de communication comprenant des guides physiques permettant de localiser le logement de module de communication (25) à l'intérieur du compartiment de manière bien ajustée.

3. Appareil compteur (1) selon la revendication 2, dans lequel le logement de module de communication (25) est agencé pour s'adapter entièrement à la place occupée par le logement de compteur, moyennant quoi il est possible d'y accéder même lorsqu'il y a un espace de montage limité pour l'appareil compteur (1).

4. Appareil compteur (1) selon la revendication 2, dans lequel le module de communication (15) intègre une alimentation électrique de communication CC (112).

5. Système de compteur, **caractérisé en ce que** le système de compteur comprend un appareil compteur (1) selon les revendications 1 à 4, et un appareil de communication (3) agencé pour se connecter à l'appareil compteur (1) selon la revendication 1, l'appareil de communication (3) comprenant un logement de module de communication (25) portant un circuit de communication, et étant agencé pour être connecté à l'appareil compteur (1) de sorte qu'il soit électriquement isolé de l'alimentation électrique par le réseau pour permettre l'accès à l'appareil de communication (1) sans affecter l'alimentation par le réseau du compteur.
